Europäisches Patentamt

European Patent Office

Office européen des brevets

(11) Numéro de publication: **0 364 354**

**A1**

## (12) DEMANDE DE BREVET EUROPEEN

(21) Numéro de dépôt: 89402792.9

(22) Date de dépôt: 10.10.89

(51) Int. Cl.5: **H01L 29/08 , H01L 29/74**

(30) Priorité: **14.10.88 FR 8813573**

(43) Date de publication de la demande:
**18.04.90 Bulletin 90/16**

(84) Etats contractants désignés:
**DE FR GB IT**

(71) Demandeur: **SGS-THOMSON MICROELECTRONICS S.A.**
**7, avenue Galliéni**
**F-94253 Gentilly Cédex(FR)**

(72) Inventeur: **Bernier, Eric**
**70 Avenue de L'Europe Logement 149**
**F-37100 Tours(FR)**

(74) Mandataire: **Rinuy, Santarelli**
**14, avenue de la Grande Armée**
**F-75017 Paris(FR)**

(54) **Thyristor asymétrique à extinction par la gâchette, muni de courts-circuits d'anode et présentant un courant de déclenchement réduit.**

(57) Les thyristors comportent classiquement une couche de cathode N divisée en domaines tels que (11) oblongs avec deux axes principaux se croisant en un centre et surmontés d'une métallisation (11a), une couche de gâchette (2) P avec une métallisation (2a) entourant les domaines (11), une couche de base (3) N, avec une première sous-couche (30) peu dopée et une seconde sous-couche (31) fortement dopée, et une couche (4) P d'anode avec une métallisation (4a) ; des zones de court-circuit (32) d'anode sont constituées par des extrémités (32) de la sous-couche (31) à travers la couche d'anode (4) jusqu'à la métallisation (4a). Selon l'invention, les zones de court-circuit (32), au lieu d'être circulaires et à l'aplomb du centre des domaines de cathode, sont des bandes étendues disposées dans des zones marginales des cellules unitaires définies par les domaines (11) de cathode, symétriquement par rapport au centre de ces cellules. Ces zones peuvent affecter la forme de bandes parallèles au grand axe, ou celle d'anneaux concentriques qui coupent les grands axes de cellules disposées en couronnes vers leurs extrémités. Le courant de déclenchement du thyristor peut être réduit d'un facteur 4, sans altérer les autres performances.

*FIG.2*

## Thyristor asymétrique à extinction par la gâchette, muni de courts-circuits d'anode et présentant un courant de déclenchement réduit.

L'invention a trait à un thyristor susceptible d'extinction par drainage de charges par la gâchette, et comportant une pastille de semiconducteur avec, en succession d'une cathode à une anode, une couche cathodique de type N divisée en domaines oblongs séparés, avec deux axes principaux, grand et petit, se croisant en un centre qui définissent respectivement des cellules unitaires, une couche de gâchette de type P qui présente une face libre entre les domaines de cathode, une couche de base comprenant une première sous-couche de type N peu dopé formant jonction avec la couche de gâchette, et une seconde sous-couche de type N fortement dopé formant jonction avec une couche danode de type P, des couches métalliques de contact étant disposées respectivement sur les faces libres des domaines de cathode, de la couche de gâchette en entourant les domaines de cathode, et de la couche d'anode, la seconde sous-couche de type N fortement dopé traversant localement la couche d'anode pour former des zones de court-circuit d'anode en contact avec la couche métallique d'anode.

Les thyristors sont communément constitués par une structure NPNP ; ils sont bloquants vis-à-vis d'une tension directe tant que le courant injecté par la gâchette est inférieur à un seuil. Lorsque le courant de gâchette dépasse le seuil, le thyristor devient passant, et le reste même si le courant de gâchette est interrompu.

Les thyristors dits GTO (gate turn of thyristor en anglais) (FR-A-84 08493, FR-A-88 00844) sont susceptibles d'être remis à l'état bloquant (ou éteints) en drainant des charges par la gâchette. Cette susceptibilité de blocage est obtenue notamment par des structures où les frontières des jonctions entre couche N de cathode et couche P de gâchette sont très développées par rapport aux surfaces de ces jonctions, pour favoriser le drainage des charges par la gâchette en dessous de la couche de cathode. Une disposition fréquente est la disposition de la couche de cathode en domaines ou îlots oblongs, dont le grand axe est nettement supérieur au petit axe.

Pour de nombreuses applications, il n'est pas utile que le thyristor soit capable de résister à des tensions inverses aussi élevées que les tensions directes pour lesquelles il est prévu ; fréquemment on dispose une diode en parallèle sur le thyristor, et passante dans le sens inverse, pour étouffer les extra courants de blocage dans des charges inductives. Aussi a-t-on développé (FR-A-81 19252) des thyristors dits "asymétriques" en raison de la dissymétrie de leurs tensions de claquage dans les sens direct et inverse. Pratiquement l'asymétrie est obtenue en divisant la couche de base de type N en une première sous-couche peu dopée, et une seconde sous-couche fortement dopée ; cette disposition double sensiblement le champ de claquage en sens direct, de sorte que l'on peut réduire notablement l'épaisseur de la couche de base ; or les pertes se produisent essentiellement dans la sous-couche N peu dopée. Tout particulièrement la structure asymétrique réduit les pertes de commutation à l'extinction.

On a muni des thyristors, tant symétriques qu'asymétriques, de courts-circuits d'anode, constitués par des zones où se prolonge la couche de base N (ou la seconde sous-couche de type N fortement dopée dans le cas de thyristors asymétriques) à travers la couche d'anode jusqu'à la métallisation d'anode.

L'effet de ces courts-circuits d'anode est d'augmenter la rapidité d'évacuation des charges électriques pendant la phase de blocage, plus spécialement la fin de cette phase, et en conséquence de réduire les pertes d'extinction.

En contrepartie, les thyristors munis de courts-circuits d'anode accusent une augmentation du courant de déclenchement, et donc des pertes au déclenchement et de la puissance de commande.

Classiquement les zones de court-circuit d'anode affectent une forme circulaire et sont disposées en regard du centre des cellules (définies par les domaines de cathode).

L'invention a pour but la création d'un thyristor asymétrique muni de courts-circuits d'anode, qui présente un courant de déclenchement réduit, et accessoirement un équilibrage de fonctionnement en extinction en évitant une concentration du courant dans certaines cellules au cours de la phase d'extinction.

Dans ce but, l'invention propose un thyristor susceptible d'extinction par drainage de charges par la gâchette, et comportant une pastille de semiconducteur avec, en succession d'une cathode à une anode, une couche cathodique de type N divisée en domaines oblongs avec deux axes principaux, grand et petit, se croisant en un centre qui définissent des cellules unitaires, une couche de gâchette de type P qui présente une face libre entre les domaines de cathode, une couche de base comprenant une première sous-couche de type N peu dopé formant jonction avec la couche de gâchette, et une seconde sous-couche de type N fortement dopé formant jonction avec une couche d'anode de type P, des couches métalliques de contact étant déposées respectivement sur les faces libres des domaines de cathode, de la couche de gâchette en entourant les dommaines de cathode, et de la couche d'anode, la sous-couche de type N fortement dopé traversant localement la couche d'anode pour former des zones de court-circuit d'anode en contact avec la couche métallique d'anode, caractérisé en ce que lesdites zones de court-circuit d'anode sont en forme de bandes allongées disposées dans des zones marginales des cellules, symétriquement par rapport aux centres de celles-ci.

On constate qu'avec la structure proposée, on gagne un facteur 4 sur le courant de déclenchement. On peut supposer que ce gain est dû au fait qu'alors que, en structure classique, le champ d'amorçage et le champ d'extraction des charges par les courts-circuits d'anode sont alignés, dans la structure de l'invention, le champ d'amorçage est perpendiculaire aux plans des couches, tandis que le champ d'extraction est parallèle à ces plans.

De plus, l'extension des bandes de court-circuit d'anode permet de pallier des défauts localisés de contact avec la métallisation d'anode, et la symétrie de leur disposition par rapport au centre de la cellule équilibre les distributions de champ d'extraction de charges.

En disposition préférée, les zones de court-circuit d'anode sont des bandes tangentes à un cercle de rayon choisi concentrique à la cellule en deux points diamétralement opposés sur un des axes principaux. Cette disposition assure géométriquement la symétrie du champ d'extraction par rapport aux deux axes principaux de chaque cellule.

Selon une disposition préférée, les zones de court-circuit sont des bandes parallèles au grand axe de cellule. Il n'y a pratiquement pas de gradient de champ suivant ce grand axe.

En variante, où les cellules sont disposées en couronnes successives avec un centre commun, les grands axes étant radiaux, les zones de court-circuit d'anode sont constituées, pour chaque couronne, par deux anneaux circulaires qui coupent respectivement le grand axe de chaque cellule au voisinage de ses extrémités. Dans cette disposition, où la courbure des anneaux à la traversée des cellules est en fait négligeable, le champ d'extraction est dirigé pour l'essentiel suivant le grand axe.

Dans cette variante, il est avantageux de ménager, dans les anneaux de court-circuit, des intervalles centrés sur le grand axe des cellules car ainsi, d'une part, on augmente l'écart entre les zones de court-circuit d'anode et le centre du canal conducteur de la cellule, et d'autre part, on évite de séparer totalement les différentes zones de couche d'anode entre les anneaux.

Des caractéristiques secondaires et d'autres avantages ressortiront d'ailleurs de la description qui va suivre, à titre d'exemple, en référence aux dessins annexés dans lesquels :

la figure 1 représente un thyristor selon l'invention, vu du côté cathode ;

la figure 2 est une coupe selon l'arc de circonférence II-II de la figure 1;

la figure 3 est une vue partielle d'un thyristor selon les figures 1 et 2, vu cu côté anode ;

la figure 4 est une vue analogue à la figure 3, d'une variante de l'invention ;

la figure 5 est une vue d'un développement de la variante de la figure 4.

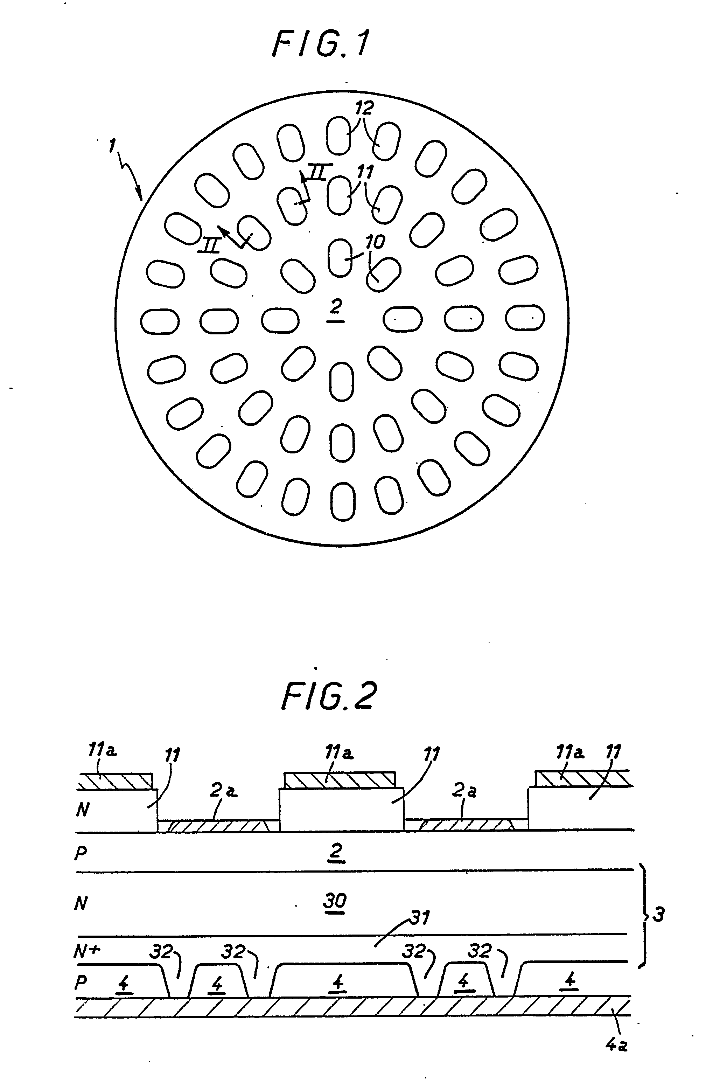

Selon la forme de réalisation choisie et représentée aux figures 1 et 2, le thyristor comporte classiquement, dans une pastille de semiconducteur 1 circulaire, une couche de cathode de type N, divisée en domaines oblongs répartis en trois couronnes 10, 11 et 12, avec deux axes principaux, un grand axe radial et un petit axe tangent à trois circonférences respectives. Une couche métallique 11a est sur la couche de cathode pour la liaison à une connexion appropriée. La couche de cathode de type N repose sur une couche de gâchette 2, de type P, qui présente une face libre entre les domaines de cathode ou îlots 10, 11 et 12, et sur laquelle est déposée une métallisation 2a, pour connexion de gâchette. Sous la couche de gâchette 2 est située une couche de base de type N 3 dans son ensemble qui comporte une première sous-couche 30 de type N peu dopée, qui forme jonction avec la couche de gâchette 2 ; cette sous-couche est relativement épaisse, son épaisseur, en combinaison avec son taux de dopage, déterminant essentiellement la tenue en tension directe. La sous-couche 30 est prolongée par une seconde sous-couche 31, fortement dopée, qui forme jonction avec une couche d'anode 4, de type P, dont la face libre porte une couche de métallisation 4a, pour une connexion d'anode.

Comme on le voit sur la figure 2, la couche d'anode 4 est traversée localement par des extensions 32 de la seconde sous-couche 31, qui viennent à fleur de la couche 4 en contact avec la métallisation 4a pour former des courts-circuits d'anode.

La division en domaines de la couche de cathode a pour effet de déterminer des cellules unitaires de thyristors à extinction commandés par la gâchette, ces cellules fonctionnant en parallèle.

On notera que tout ce qui précède est classique, structure en quatre couches NPNP du thyristor, disposition de la cathode sur la gâchette en îlots oblongs qui permet la commande en extinction par la gâchette par drainage, drainage latéral des charges, l'action de la gâchette restant effective pratiquement jusqu'au grand axe, division de la couche de base en une sous-couche peu dopée et une couche fortement dopée qui donne au thyristor une résistance au claquage asymétrique (forte en direct, faible en inverse), et aménagement de courts-circuits d'anode pour réduire les pertes à l'extinction en améliorant la rapidité d'écoulement des charges en phase d'extinction.

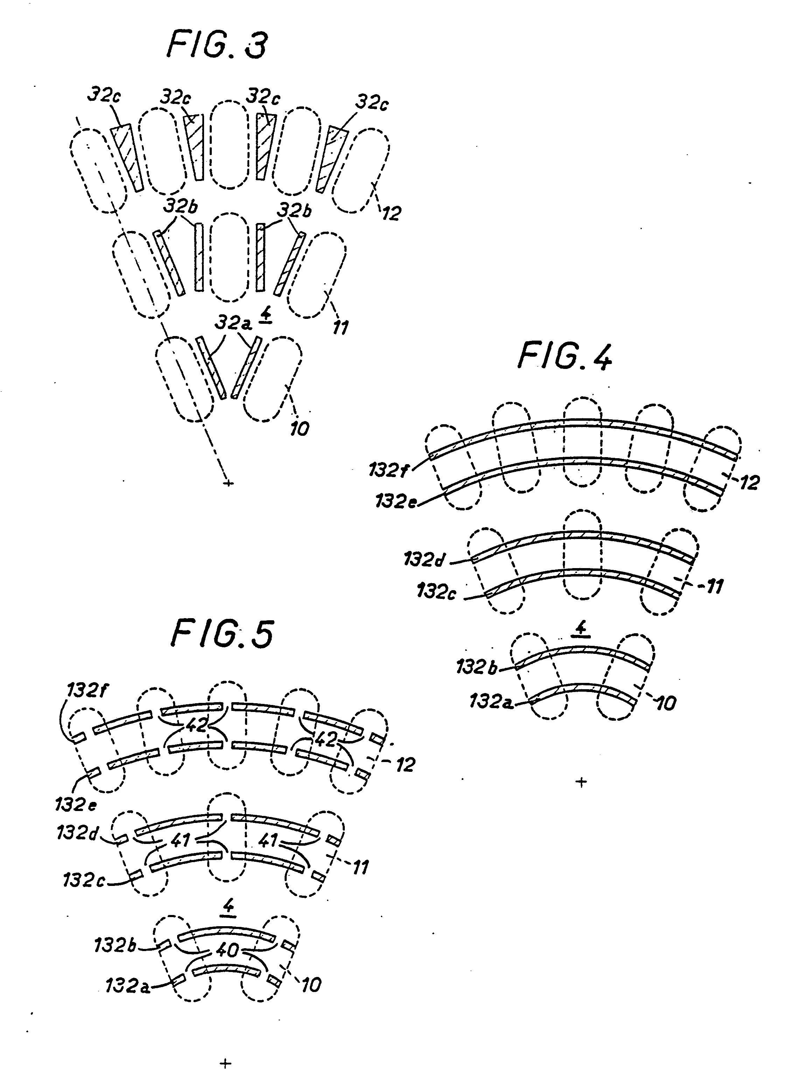

L'originalité de l'invention réside dans la topographie des courts-circuits d'anode, qui sera décrite et commentée en référence aux figures 3 à 5.

On comprendra que les aspects classiques des thyristors GTO asymétriques à court-circuit d'anode s'étendent au taux de dopage et choix des dopants pour l'exécution des différentes couches et sous-couches, et processus de fabrication du thyristor avec croissance des couches de part et d'autre de la couche de base 3.

On rappelle que, classiquement, les courts-circuits d'anode sont des extensions circulaires centrées à l'aplomb du centre des domaines de cathode et donc des cellules unitaires, au croisement des axes principaux, c'est-à-dire dans l'axe de la décharge principale.

Cette disposition, qui rapproche au maximum le collecteur de charge du site où la densité de charge est maximale, est efficace pour la collection des charges pendant la phase d'extinction. Mais en contrepartie elle contribue à augmenter le courant de gâchette nécessaire pour amorcer la décharge. La réduction des pertes à l'extinction est compensée par une augmentation des pertes à l'allumage.

Selon la disposition de l'invention représentée figure 3, les courts-circuits d'anode sont constitués de bandes étroites 32a, $32_b$ et 32c, disposées parallèlement au grand axe des domaines de cathode respectivement 10, 11 et 12. En fait les bandes 32c ont la forme de trapèzes isocèles allongés dont les côtés, non parallèles entre eux, sont parallèles respectivement aux grands axes de deux domaines de cathode entre lesquels ils sont disposés.

On comprend que la section droite de la décharge entre un domaine de cathode et l'anode est gouvernée par la forme en plan du domaine de cathode, la densité de courant croissant des zones marginales au centre de la cellule unitaire. Ainsi les bandes étendues de court-circuit d'anode parallèlement au grand axe sont-elles disposées dans des zones marginales de la décharge, à l'écart du centre où la décharge initiale est créée, de sorte que leur contribution au courant de gâchette en phase d'allumage est réduite, mais suffisamment près du centre de la décharge pour que la collection de charge à l'extinction soit efficace. On notera que l'allongement du trajet des charges collectées par les courts-circuits d'anode est compensé par une augmentation de la largeur de la zone correspondante, et que le parallélisme des bandes de court-circuit et du grand axe confère aux bandes une efficacité sensiblement régulière sur toute leur longueur.

Dans la pratique, on constate que la disposition de l'invention réduit d'un facteur 4 le courant d'amorçage de la gâchette par rapport aux dispositions classiques, les autres caractéristiques et les conditions opératoires restant inchangées.

La disposition représentée à la figure 4 conduit à des résultats pratiquement égaux ; les bandes de court-circuit d'anode sont ici des anneaux 132a, 132b, 132c, 132d, 132e et 132f, concentriques à la pastille 1 (figure 1). Ces anneaux passent dans les zones marginales des cellules unitaires, vers les extrémités du grand axe des domaines de cathode. Comme dans la disposition de la figure 3, les anneaux de court-circuit d'anode sont à l'écart du centre de la décharge, et cependant suffisamment proches de ce centre pour être en état de collecter les charges lors de la phase d'extinction.

On remarquera que les anneaux 132a et 132b pour la couronne des domaines 10, 132c et 132d pour la couronne 11 et 132e, 132f pour la couronne 12 sont à égale distance du centre des cellules respectives.

Pour une définition géométrique commune des dispositions des figures 3 et 4, compte tenu de la fonction technique recherchée, on peut exprimer que les bandes qui constituent les courts-circuits d'anode sont tangentes à un cercle de rayon choisi concentrique à la cellule considérée, en deux point diamétralement opposés sur l'un des axes principaux. Une telle définition géométrique pourrait paraître quelque peu arbitraire, si l'on ne se souvenait pas que la réalisation d'un dispositif semiconducteur passe toujours par un stade de dessin graphique.

Selon la disposition de la figure 4, les anneaux sont continus.

Aussi les régions de la couche d'anode 4 se trouvent-elles divisées en couronnes concentriques reliées entre elles uniquement par la métallisation. Dans la disposition représentée sur la figure 5, les anneaux de court-circuit 232a, 232b, 232c, 232d, 232e, 232f sont interrompus par des intervalles 40 (232a, 232b), 41 (232c, 232d), 42 (232e, 232f) centrés sur les grands axes des cellules 10, 11, 12 respectivement. Ces intervalles constituent d'une part des ponts qui mettent en communication les différentes couronnes de la couche P d'anode, et d'autre part se trouvent situés aux points des anneaux de court-circuit d'anode où le courant de décharge est le plus élevé.

Bien entendu, l'invention n'est pas limitée aux exemples décrits, mais en embrasse toutes les variantes d'exécution, dans le cadre des revendications.

## Revendications

1. Thyristor susceptible d'extinction par drainage de charges par la gâchette, et comportant une pastille de semiconducteur (1) avec, en succession d'une cathode (10, 11, 12) à une anode (4), une couche (10, 11, 12) cathodique de type N divisée en domaines oblongs (10, 11, 12) avec deux axes principaux, grand et petit, se croisant en un centre qui définissent des cellules unitaires, une couche (2) de gâchette de type P qui présente une face libre entre les domaines (10, 11, 12) de cathode, une couche de base (3) comprenant une première sous-couche (30) de type N peu dopé formant jonction avec la couche (2) de gâchette, et une seconde sous-couche (31) de type N fortement dopé formant jonction avec une couche d'anode (4) de type P, des couches métalliques de contact (11a, 2a, 4a) étant déposées respectivement sur les faces libres des domaines (11) de cathode, de la couche de gâchette (2) en entourant les domaines (10, 11, 12) de cathode, et de la couche (4) d'anode, la sous-couche de type N fortement dopé (31) traversant localement la couche (4) d'anode pour former des zones (32) de court-circuit d'anode en contact avec la couche métallique (4a) d'anode, caractérisé en ce que lesdites zones (32) de court-circuit d'anode sont en forme de bandes allongées (32, 132, 232) disposées dans des zones marginales des cellules, symétriquement par rapport aux centres de celles-ci.

2. Thyristor selon la revendication 1, caractérisé en ce que, pour chaque cellule, les zones de court-circuit d'anode (32, 132, 232) sont des bandes tangentes à un cercle de rayon choisi concentrique à la cellule, en deux points diamétralement opposés sur l'un des axes principaux.

3. Thyristor selon la revendication 2, caractérisé en ce que les zones de court-circuit d'anode sont des bandes (32a, 32b, 32c) parallèles au grand axe de cellule.

4. Thyristor selon la revendication 2, où les cellules sont disposées en couronnes successives (10, 11, 12) avec un centre commun, les grands axes de cellule étant radiaux, caractérisé en ce que les zones de court-circuit d'anode sont constituées de deux anneaux (132a, 232a, 132c, 232c, 132e, 232e ; 132b, 232b, 132d, 232d, 132f, 232f) par couronne (10, 11, 12), coupant respectivement le grand axe de chaque cellule (10, 11, 12) au voisinage de ses extrémités.

5. Thyristor selon la revendication 4, caractérisé en ce que les anneaux (232a, 232b ; 232c, 232d ; 232e, 232f) constituant zones de court-circuit d'anode sont interrompus par des intervalles (40, 41, 42) centrés sur le grand axe de chaque cellule (10, 11, 12).

# FIG.1

# FIG.2

FIG.3

FIG.4

FIG.5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 200 863  (BBC AG BROWN, BOVERI & CIE)<br>* Page 2, colonne 2, ligne 17; page 3, colonne 3, lignes 27-44; page 4, colonne 6, lignes 45-51; page 5, colonne 7, lignes 7-11; figures 1,4,6 *<br>--- | 1,2,4 | H 01 L  29/08<br>H 01 L  29/74 |
| Y | US-A-3 324 359  (F.E. GENTRY)<br>* Colonne 8, ligne 48 - colonne 9, ligne 19; colonne 9, ligne 66 - colonne 10, ligne 3; figure 3 *<br>--- | 1,2,4 | |
| A | EP-A-0 009 367  (HITACHI LTD)<br>* Page 16, ligne 22 - page 18, ligne 18; page 19, lignes 7-12; figures 4,5,8 *<br>--- | 1-3,5 | |
| A | EP-A-0 022 355  (HITACHI LTD.)<br>* Page 11, ligne 9 - page 15, ligne 14; page 16, lignes 10-18; figures 7,8,10 *<br>--- | 1-3,5 | |
| A | EP-A-0 151 019  (WESTINGHOUSE BRAKE AND SIGNAL CO. LTD)<br>* Page 3, ligne 12 - page 4, ligne 7; page 6, lignes 1-11; figures 1,2 *<br>--- | 1,2,4,5 | DOMAINES TECHNIQUES RECHERCHES (Int. Cl.5)<br><br>H 01 L |
| A | DE-A-3 535 457  (BBC AG BROWN, BOVERI & CIE)<br>* Page 26, ligne 14 - page 28, ligne 13; figure 6 *<br>----- | 1,2,4 | |

Le présent rapport a été établi pour toutes les revendications

| Lieu de la recherche | Date d'achèvement de la recherche | Examinateur |
|---|---|---|
| LA HAYE | 24-11-1989 | MORVAN D.L.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)